# EUROPEAN PATENT SPECIFICATION

(11) **EP 2 909 359 B1**
(45) Date of publication and mention of the grant of the patent: **24.08.2016**
(21) Application number: 13777048.3
(22) Date of filing: 15.10.2013
(51) Int. Cl.: C23C 30/00, B23B 27/14, C23C 16/04, C23C 16/02

(54) **COATED CUTTING TOOL WITH PATTERNED SURFACE AREA**
BESCHICHTETES HARTMETALLSCHNEIDWERKZEUG MIT STRUKTURIERTEM OBERFLÄCHENBEREICH
OUTIL DE COUPE AU CARBURE CÉMENTÉ REVÊTU AVEC ZONE DE SURFACE À MOTIFS

(30) Priority: 16.10.2012 EP 12188695
(43) Date of publication of application: 26.08.2015
(73) Proprietor: Sandvik Intellectual Property AB, 811 81 Sandviken (SE)
(72) Inventor: BJÖRMANDER, Carl, SE-163 46 Spånga (SE); BOEHNKE, David, 72762 Reutlingen (DE)
(86) International application number: PCT/EP2013/071531
(87) International publication number: WO 2014/060414

(56) References cited:
- EP-A1- 0 860 515
- EP-A1- 2 210 692
- EP-A2- 0 787 820
- US-A- 5 558 789
- US-A- 5 935 323
- US-A- 6 068 913

## Description

### Technical field

The present invention relates to coated cutting tools suitable for turning, milling, drilling or other chip forming machining methods.

### Background

Coating of cemented carbide cutting tools with hard refractory coatings have dramatically improved wear resistance and cutting performance of the tools, and thereby increased tool life and productivity in machining operations. In order to further improve the wear resistance and the performance of the tools they are typically optimized with respect to material properties of the cemented carbide substrate and the coating and with respect to the geometry of the tool for a particular application. The optimization of the material properties is typically aiming at diminishing the predominant wear mechanism of the particular application and the optimization of the geometry of the cutting tools is typically aiming at improvement of the cutting process, such as the chip removal or the roughness of the work piece. Hence, a positive effect accomplished by one optimization may have no or negative effect on other properties of the cutting tool and/or the cutting process.

For example, coated cemented carbide cutting tool insert often comprise a coating with an inner layer consisting of one or more sub-layers selected from titanium carbide, titanium nitride, titanium carbonitride, titanium oxycarbide and titanium oxycarbonitride sub-layers, and an outer alumina layer. The alumina layer is known to improve resistance to crater wear on the rake face of the cutting tool insert, whereas on the flank face of the cutting tool insert the alumina has less attractive properties and the TiCN contributes with high abrasive wear resistance. Since the crater wear on the rake face in many applications is the fatal wear mechanism the properties of the alumina layer are prioritized. One way to improve the crater wear resistance is to increase the thickness of the alumina layer. However, this optimization with respect to crater wear is at the expense of other properties, such as resistance to flaking of the coating, in particular on the edge line or the flank face.

As one solution to this different post treatments have been used. By way of example, US 5,776,588 discloses a cutting tool coated with a multi-layered wear resistant coating including e.g. an innermost TiCN layer, an intermediate Al₂O₃ layer and an outermost TiN layer. The TiN layer and the Al₂O₃ layer are removed by mechanical means such as a vibratory tumbling, brushing, shot blasting, grinding from the edge line of the cutting tool, so that the innermost TiCN layer is exposed, in order to improve the resistance to flaking of the coating at the edge line. In another example, US 7,431,747 discloses a cutting tool coated with a multi-layered wear resistant coating including an alumina layer deposited on a hard material layer. The alumina layer is selectively removed by means of laser treatment from at least a portion of the flank face so that the underlying hard material layer is exposed in order to simultaneously avoid increase in the width of the wear mark on the flank face and retention of the resistance to crater wear on the rake face.

Albeit these post treatments may improve the overall properties of the cutting performance of the cutting tool insert, the maximum thickness of the alumina layer, and hence the improvement of crater wear resistance due to the thickness increase, is limited.

### Summary

One object of the invention is to improve cutting performance of a coated cutting tool. Another object is to improve wear resistance of the coated cutting tool. Yet another object of the invention is to improve the crater wear resistance of a coated cutting tool, in particular by providing an improved wear resistance locally on the coated cutting tool without impairing properties of other portions of the coated cutting tool. Another object is to provide an improved cutting tool for machining in iron based materials such as steels.

This is accomplished by a coated cutting tool in accordance with the independent claims. Preferred embodiments are disclosed in the dependent claims.

A coated cutting tool according to the present invention comprises a substrate and a surface coating deposited on the substrate and covering at least a portion of the substrate. The surface coating has a thickness T_{c} and the substrate comprises a plurality of recesses into the substrate within a patterned surface area within the coated portion of the substrate. Each of said recesses has a depth D which is smaller than 100 µm, preferably < 75 µm, and a width W, at half depth [D/2] of the recess, where Wᵢ≤2T_{c}. T_{c} is between 2 µm and 30 µm, preferably between 5 and 25 µm, more preferably between 5 µm and 22 µm, and the recess is at least partly filled by the surface coating.

The cutting tool according to the present invention has shown higher crater wear resistance compared to a cutting tool not provided with such a patterned surface area. The crater wear is typically a wear of a chemical and abrasive type. Both the mechanical load and the temperature are very high in this area. The tool according to the present invention has improved properties in at least one of these aspects.

One advantage with the formation of recesses in the substrate is that it provides an increased surface area of the substrate. An applied coating into the recesses provides a coating with an extension down into the substrate. Thus the filled recesses provides an effective thickness of the coating within the patterned surface area that is larger than T_{c} the nominal thickness of the coating itself. The Increased volume of coating material in the surface area is one reason for the improvement. Locally the effective thickness of the coating has been increased due to the pattern. An increased coating thickness implies an increased wear resistance as long as the coating is worn continuously and do not spall off. Since recesses can be formed in areas that are critical with respect to wear, the wear resistance of the coated cutting tool is improved without impairing the performance with respect to other areas of the cutting tool.

Another advantage with the recesses in the substrate is that the orientation of the coating/substrate interface is not parallel to the sliding direction of for example a chip sliding at the surface of the tool. This increases the resistance to delamination.

A cutting tool in accordance with the present invention may be a cutting tool insert or a round tool.

Suitable materials for substrate are ceramics, cermets, cemented carbides, cubic boron nitride, polycrystalline diamond or high speed steel, preferably cemented carbides.

The patterned surface area is preferably placed in a critical area with respect to wear. The patterned surface area may at least partly cover the flank face and/or the rake face. If the pattern is on the rake face the patterned surface area is preferably placed at a distance of at least 100 µm, preferably more than 150 µm from the edge line. If the patterned surface area is on the flank face, said area is preferably at least 50 µm from the edge line. The edge line is here defined as the line along the edge of the tool when studying the patterned surface area from a direction perpendicular to the patterned surface area. A pattern placed too close to the edge would imply an increased risk for an uneven wear of the cutting edge.

The cutting tool of the present invention comprises a surface coating deposited on the substrate. This surface coating is typically a wear resistant coating covering at least areas subjected to wear during cutting. If the cutting tool is an insert with a rake face and a flank face, the coating can be applied on one or both of these faces.

The coating thickness T_{c} is the thickness of the coating as deposited on a flat surface outside a recess. The surface of the substrate within the patterned area but outside a recess is in this application called a first surface of the substrate. This first surface of the substrate is a surface arranged with recesses, and the surfaces that defines each recess, the walls and bottom of the recess, are not a part of the first surface of the substrate.

The width Wₑ of the recess is considered to be the width at the first surface of the substrate. The width Wᵢ is the width of the recess at half depth [D/2] of the recess and Wᵢ≤2T_{c}. In one embodiment Wₑ <2T_{c}.

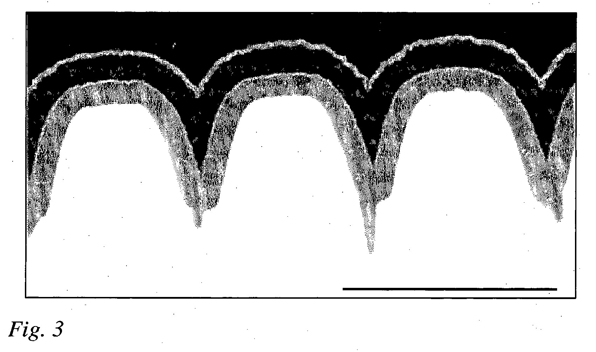

The recesses have a depth D which is the distance from the first surface of the substrate, i.e the substrate surface outside the recess, and down to the bottom of the recess. The bottom of the recess can comprise artifacts or irregularities such as local deep narrow holes caused by for example a non-optimized laser process. Examples of such artifacts can be seen in Fig. 3. The depth D is preferably more than 2 µm, more preferably more than 5 µm. The depth D is less than 100 µm, preferably < 75 µm. The depth should be large enough to impact the life time of the tool, and small enough not to negatively impact the toughness of the edge. A too large depth of the recess would not increase the life time of the tool, since a large wear depth anyhow weakens the edge of the tool. In one embodiment the aspect ratio of the recess is D/Wₑ <2, preferably 0.5-1.5.

A coated cutting tool in accordance with one embodiment of the present invention comprises a substrate, preferably made of cemented carbide, and a coating. The substrate comprises a geometric pattern with recesses, such as holes or grooves, in the surface thereof. These recesses are at least partly filled with the coating such that the coating at least has started to coalesce in the recesses. Each recess is at least partly filled by the surface coating such that the surface coating is grown together in the recess. This is accomplished during the deposition of the surface coating. Since the width at some depth in the recess is less than twice the total thickness of the surface coatings growing on opposite sidewalls of the recess a portion of the surface coating will finally coalesce in the recess. The coating can have a first initial type of growth replicating the substrate surface profile, and a second type of growth wherein the coating coalesce within the recess such that a portion of the surface of a growing coating meets another portion of surface of a growing coating, and the coating coalesce when the growth of the coating is a second type of growth. This is advantageous since it provides a locally larger coating thickness, and thereby a higher wear resistance.

In accordance with one embodiment of the present invention the cutting tool is provided with a coating, wherein the thickness of the coating deposited in the recess is larger than the coating deposited on the first surface of the substrate.

The shape of the recess is preferably such that the width at the bottom of the recess is smaller than the width Wₑ at the first surface of the substrate. This is advantageous due to that voids and pores can be avoided. The recess can have side walls that are perpendicular to the first substrate surface, or the walls can be inclined. The angle between the sidewall of a recess and the first substrate surface is preferably between 45° and 90°. In one embodiment of the present invention the surface coating has an outer surface and wherein a point at the maximum depth of a remaining recess at/on the outer surface is located above the first surface of the substrate such that the coating is continuous along a line parallel to the first surface of the substrate across several recesses. This can for example be studied at a cross section of the tool. This is advantageous in increased wear resistance.

In one embodiment of the invention the coating completely fills the recesses and covers surrounding substrate surfaces, at least within the patterned surface area. In one embodiment of the invention, the underlying structure of the patterned substrate surface area is not retained on the outer surface of the coating. This is advantageous since a lower surface roughness often implies a lower wear rate.

In one embodiment of the present invention the recesses are arranged in a pattern with a pitch between adjacent recesses that is larger than 10 µm and less than 100 µm, preferably between 70 µm and 90 µm. The pitch can vary within the patterned area, but preferably the pitch is constant within the patterned area. The preferred pitch P depends on the specific width Wₑ of the recess, such that the pitch P should always exceed the width Wₑ.

In one embodiment of the present invention the patterned surface area is provided with recesses covering 50-98% of the nominal surface area, preferably 75-95%. The nominal surface area of the patterned area is equivalent to the first surface of the substrate if no recesses are present. A higher surface coverage results in a larger amount of coating down into the substrate. The coverage should not be too high since recesses that are getting too close tend to lower the first surface of the substrate. A too low surface coverage leads to a wear rate similar to a surface without any recesses.

In one embodiment of the present invention the cutting tool is provided with a surface coating that is conformal, i.e. deposited by a conformal deposition method. In one embodiment of the invention the coating is a CVD (chemical vapor deposition) coating. Due to the properties of the CVD deposition process the coatings are substantially conformal and thus the coating on the substrate surfaces within the recesses becomes as thick as on other substrate surfaces, at least until the coating grow together or coalesce in the recess as disclosed above.

In another embodiment the coating is a PVD (Physical vapor deposition) coating.

In one embodiment of the present invention, the recesses are grooves. The grooves can be arranged in an irregular or a regular pattern. The grooves can be oriented parallel to or perpendicular to the cutting edge. As an alternative, the grooves can be oriented in a specific angle relative to the cutting edge. The grooves can have a specific length and width, or these can vary over the patterned area.

The recesses may have "equiaxed width" for example be of circular or square shape. Alternatively, the recesses may be elongated, thereby forming short grooves. Preferable the recesses are arranged in tracks arranged in a corresponding pattern as the grooves in the above embodiment.

In one embodiment of the present invention, the recess is a pit or a groove with a curved outer shape such as a circle, a ring or an oval. The recesses can for example comprise a ring with a larger radius enclosing rings with smaller radius. This is advantageous in that the distance between two adjacent recesses can be arranged to be close to independent of orientation.

In one embodiment of the present invention, the recesses comprise grooves arranged in a pattern with crossing grooves forming islands enclosed by the grooves. The maximum width of one island is preferably less than 100 µm, more preferably less than 70 µm, even more preferably less than 50 µm. This is advantageous since typically thermal cracks of a CVD coating generate islands that has shown to be in the range of 50-70 µm. The coating applied on the recesses can be seen as a coating with artificial cracks. These artificial cracks seems to work as traps or a stress reservoirs such that thermal crack in the coating itself can be avoided. Thermal cracks in a coating do always imply an increased risk for wear and coating spallation.

In one embodiment of the present invention, the coated cutting tool comprises a rake face and a flank face and the patterned surface area is on a rake face of the coated cutting tool. The coated cutting tool is preferably covering a crater area on the rake face of the coated cutting tool, wherein the crater area is an area with increased risk for crater wear in cutting operations.

The coating may comprise one or more layers. Suitable materials to be deposited as a layer are compounds of one or several first elements selected from Group 4, Group 5, Group 6 (IUPAC) and one or several second elements selected from N, B, O, C.

In one embodiment of the present invention, the coating comprises one or several layers of compound of one or several first elements selected from Group 4, Group 5, Group 6 (IUPAC), Al and Si, and one or several second elements selected from N, B, O, C.

In one embodiment of the present invention at least half the thickness of the coating comprises one or several layers consisting of compound of one or several first elements selected from Group 4, Group 5, Group 6 (IUPAC), Al and Si, and one or several second elements selected from N, B, O, C.

In one embodiment of the present invention the coating consists of one or more layers consisting of compound of one or several first elements selected from Group 4, Group 5, Group 6 I (IUPAC), Al and Si, and one or several second elements selected from N, B, O, C.

Preferred compounds comprise Ti(C,O,N), Ti(C,N), TiC, TiN, or combinations thereof. Preferably a MTCVD process is used for at least one of these layers. In one embodiment the coating comprises at least one Al₂O₃ layer and at least one refractory metal nitride, carbide or carbonitride layer selected from the group of Ti(C,N), TiN, TiC, Ti(C,N,O). The refractory metal nitride, carbide or carbonitride layer is preferably deposited prior to the Al₂O₃ layer.

The coated cutting tool of the present invention comprises a coating with an inner layer with thickness T_{cl} and an outer layer with thickness T_{co}. The inner layer may be made of Ti(C,O,N), Ti(C,N), TiC, TiN, or combinations thereof and the outer layer may be made of Al₂O₃. The inner layer may have a thickness T_{cl} of 2-10 µm and the outer layer may have a thickness T_{co} of 1-10 µm.

In one embodiment Wₗ<2T_{cl}, preferably Wₑ<2_{Tcl}. If the inner layer for example comprises Ti(C,N) this implies an increased abrasive wear resistance.

In another embodiment Wᵢ<2(T_{ci} +T_{co}), preferably We<2(T_{ci}, +T_{co}). This is advantageous since the recess comprises material from both the inner layer and the outer layer. If the outer layer is for example Al₂O₃ this implies an increased thermal resistance effect. It is advantageous that a patterned surface area comprising a thermal barrier layer, such as an alumina layer, is placed in the area where crater wear usually appears, i.e. on the rake face of the cutting tool insert where the temperature during machining is the highest.

A method of manufacturing a coated cutting tool in accordance with one embodiment of the invention comprises the steps of: providing a substrate, preferably made of cemented carbide; prior to coating, forming, preferably by laser machining, a patterned surface area of the substrate, which recesses has a depth D, a width Wₑ at the first surface of the substrate and a width Wₗ at half depth [D/2] of the recess, and an aspect ratio D/Wₑ<2; depositing a coating onto the patterned surface area, which coating has a thickness T_{c} of 2-30 µm, wherein Wₗ<2T_{c} and the recesses are at least partly filled by the surface coating.

Other ways of forming a surface pattern can be by embossing, by focused ion beam, dry etching such as reactive ion etching (RIE), electric discharge machining, wet etching or any other technique known in the art for forming surface patterns in accordance with the appended claims.

The recesses may be formed with laser machining. The laser equipment used is preferably a pico second laser. Laser machining is performed by exposing the substrate to a laser beam. The laser beam is scanned in multiple or single scans to form the recesses. By laser machining the substrate can be structured in almost any geometric pattern, for example grooves or holes. Moreover the laser machining is fast as compared to many other machining techniques. The geometric pattern formed may be ordered or disordered. Regarding the control of density of recesses, this depends on how close recesses can be formed by the particular laser machining system used, which is matter of at least the optical system (lenses), laser parameters (peak power, pulse length, pulse frequency), substrate material, etc.

The method of manufacturing the surface patterns in accordance with the above identified invention may further comprises a final blasting step of the tool as deposited with a surface coating on at least the patterned area. This is advantageous in that a smoothening effect can be reached whereby minor retained patterns on the surface at the patterned area can be reduced in dimensions or removed.

Other objects, advantages and novel features of the invention will become apparent from the following detailed description of the invention when considered in conjunction with the accompanying drawings and claims.

### Brief description of drawings

Embodiments of the invention will now be described with reference to the accompanying drawings, wherein:
FIG. 1 schematically illustrates part of an insert provided with a geometrical pattern of recesses provided with a coating,
FIG. 2 shows pictures of A) perpendicular, B) parallel, C) crossed recesses formed by laser on a rake face of an insert and D) shows a reference,
FIG. 3 shows an scanning electron microscope (SEM) picture of a cross section of a groove in a cutting tool surface. The substrate is coated with an inner Ti(C,N) layer and thereon a Al₂O₃ layer which layer has grown together in the recess,
FIG. 4 shows pictures of the samples A-D shown in Fig. 2, after 28 minutes operation in accordance with Example 1,
FIG. 5 shows a SEM picture of a portion of the crater wear of the inserts shown in Fig. 3C, and
FIG. 6 shows pictures of the samples A-D shown in Fig. 2, after 36 minutes operation In accordance with Example 1.

### Detailed description

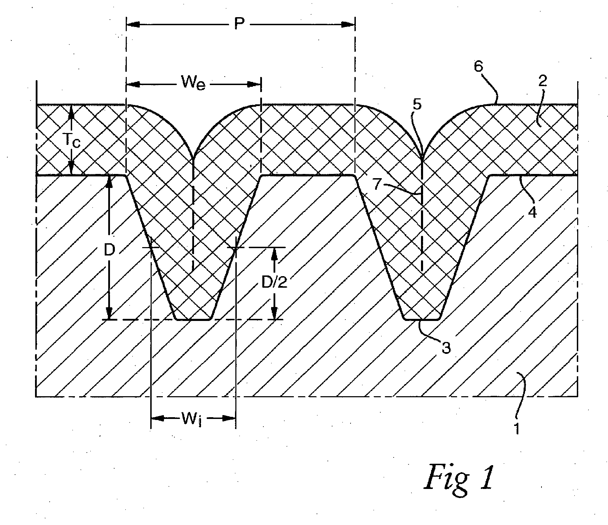

Figure 1 is a schematic view of a surface provided with recesses, wherein each recess has a depth D, a width Wₑ at the first surface 4 of the substrate 1, and a width Wᵢ at half the depth D/2. The recesses are arranged with a pitch P between two adjacent recesses. A coating 2 with a thickness T_{c} is applied to the substrate 1. The coating 2 covers the first surface 4 of the substrate 1 and also the surfaces 3 in the recess. The coating 2 coalesce along the ditched line 7 in the recess, where coating surfaces growing in different directions has met each other. The surface coating 2 has an outer surface 6 and the point 5 at the maximum depth of any remaining recess at the outer surface 6. The coating is continuous along a line across several recesses parallel to the first surface 4 of the substrate 1. As can be seen the sidewalls of the recess are inclined relatively the first substrate surface 4.

As can be seen in the figure 1, these recesses are filled by the surface coating, since a point 5 at the maximum depth of the remaining recess at the outer surface 6 is located above a first surface 4 of the substrate 1. In an alternative embodiment, not shown, the recesses are not completely filled by the surface coating.

### Example 1

Grooves were formed in a cutting insert 120408 NM4 made of cemented carbide using a Lasertech 40S pico second laser (50W) from DMG. The wavelength was 1064 nm, the spot diameter 40-50 µm and the pulse frequency 500 kHz. The scanner velocity was 2000 mm/s and the thickness of the layer removed per scan was 0.6 µm. The movement of the laser spot was parallel.

The substrate is made of cemented carbide and comprises 7.5 wt% Co, 2.9 wt% TaC, 0.5 wt% NbC, 1.9 wt% TiC, 0.4 wt% TiN and balance WC. The cemented carbide substrate has a surface zone 22-30 µm free of gamma phase, a bulk hardness of 1450-1550 HV3 and a Hc [kA/m] of 12.9-14.4.

The patterned surface area is placed in a position on the rake face of the cutting tool insert where crater wear usually appear and spaced 0.15 mm from the cutting edges. The patterned area has an extension of 2x3 mm.

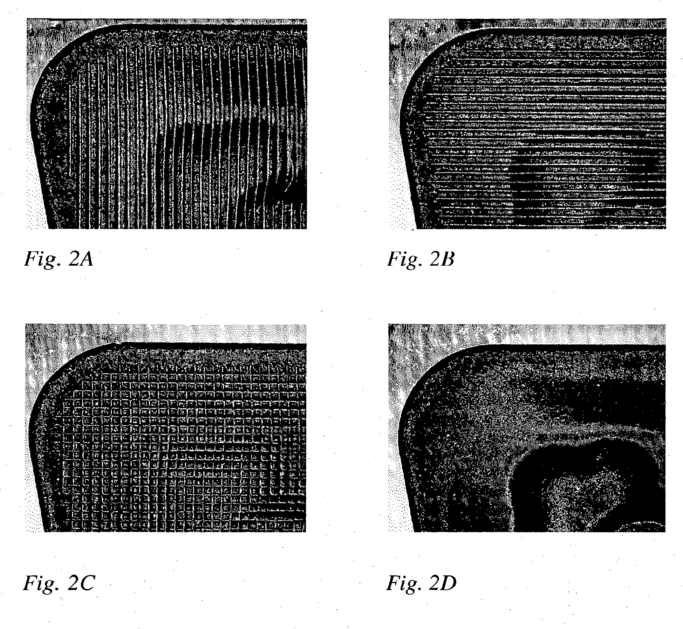

Three types of patterns of grooves were made:
- grooves perpendicular to the main cutting edge (sample A, invention), as shown in Fig. 2A,
- grooves in parallel with the main cutting edge (sample B, invention), as shown in Fig. 2B,
- parallel grooves crossing each other at right angle forming a crossed pattern of grooves surrounding islands of (sample C, invention), as shown in Fig. 2C.

These patterned tools were compared in performance with a reference sample not laser treated and not comprising any patterned surface area, but comprising the corresponding substrate and coatings, (sample D, prior art), as shown in Fig. 2D.

The geometry of these patterned surfaces were studied in cross section in a light microscope. The average maximum width Wₑ of the grooves at the first surface of the substrate is about 45-50 µm and the average width Wᵢ at half the depth (D/2) is about 27 µm. The depth D of the grooves is about 45-55 µm. The pitch P is about 80 µm. The side walls of the grooves are slightly inclined and thereby the surface area coverage at a level at the bottom of the groove is lower than the surface area coverage at the first surface of the substrate. In this particular case a surface area coverage for the crossed pattern is of about 83% coating at the first surface of the substrate and about 44% surface area coverage at the depth of about 50 µm. The profile is shown in Fig. 1 and Fig. 3. Figure 3 is a SEM micrograph of a cross section of sample C.

After laser micromachining the cutting inserts were coated in a CVD reactor. The surface coating consists of an inner 10 µm thick MT-Ti(C,N) layer and an outer 10 µm thick α-alumina layer. An 1 µm thick outermost TiN coating was deposited. All the inserts were finally treated with a wet blasting with 220 mesh Al₂O₃ grits.

The coated cutting tools made in accordance with above were evaluated with respect to crater wear in a continuous longitudinal turning operation in ball bearing steel (Ovako 825B) with depth of cut 2 mm, cutting speed 220 m/min, feed speed 0.3 mm/rev and using coolant.

The wear of the reference cutting tool was studied each 2 minutes in a light microscope and the size of exposed area of the substrate was measured. The wear of the patterned cutting tools were measured after finished tests. In a worn patterned area, each of the exposed substrate subareas were added and the sum of exposed subarea is presented in Table 1.

The cutting tools can be considered to be worn out when a stop criteria of an exposed substrate in the crater area of 0.2 mm² is reached and at the cutting time required to reach this criteria. This stop criteria was reached at 28 minutes for the Reference insert. The stop criteria for the parallel and the perpendicular were reached at 44 minutes. The turning of the reference was continued although the stop criteria was reached , but had to be stopped at 40 minutes due to an expected soon forthcoming total breakage of the tool. At 44 minutes crossed had not reached the above stop criteria, as can be seen in Table 1.

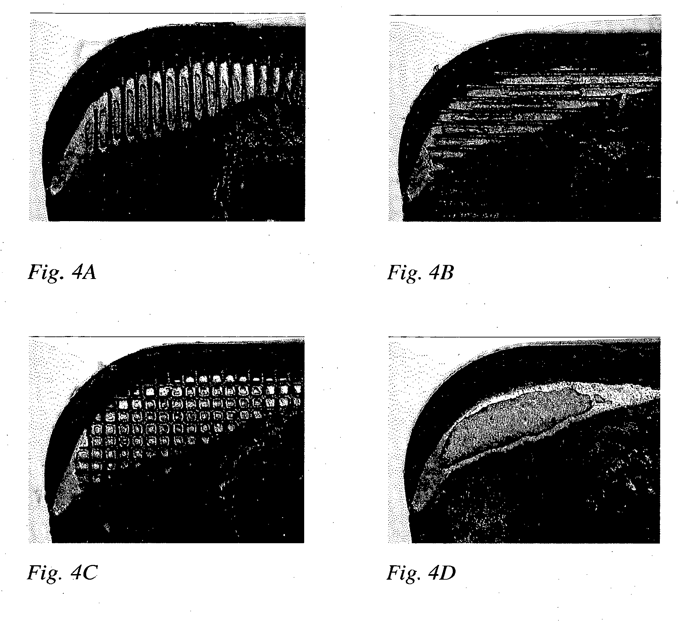

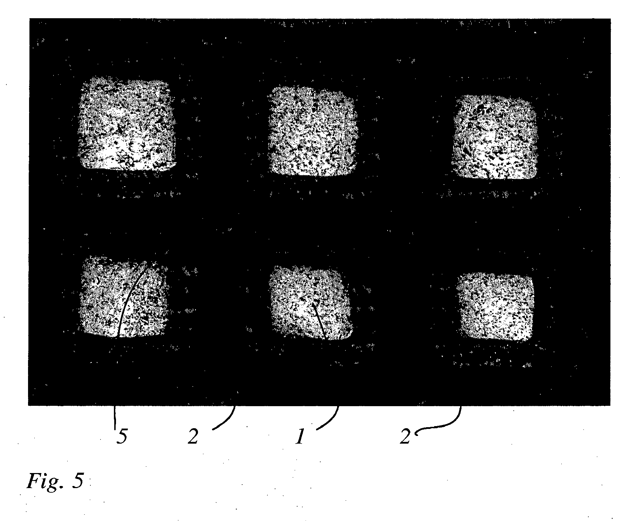

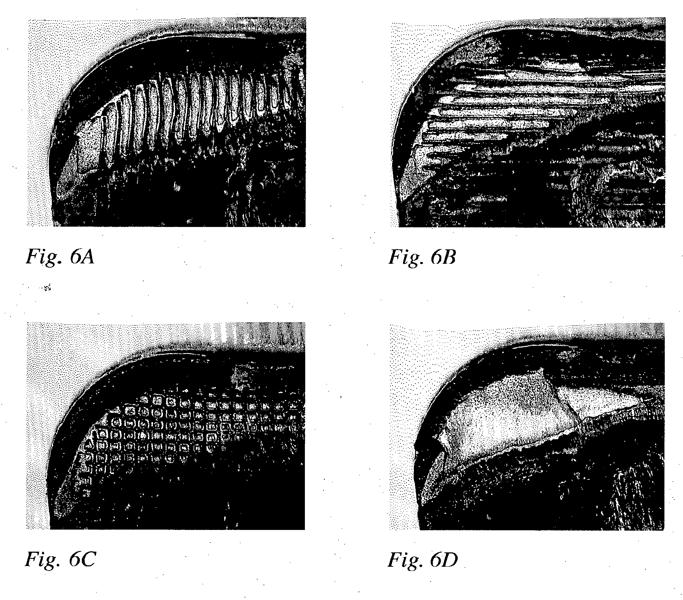

Figure 4A-D shows the samples after 28 minutes operation. The exposed substrate area is obviously larger for the reference sample D than for all the other samples. Figure 5 is a SEM micrograph showing in close up a central part of the worn surface of sample C, shown in Fig. 4C. Figure 6A-D shows the samples after 36 minutes operation. The reference sample shown in Fig. 6D shows excessive crater wear.

Even though the same depth of the crater wear results in a larger exposed substrate area for the reference compared to a lower exposed substrate area, as long as the recesses are not worn through, this value is considered to indicating a wear rate that differs between the patterned tools and the reference tools. And the increase in wear rate of the reference tool between 36 minutes and 40 minutes operation time confirms this behavior. Just to confirm this, the depth of the wear mark was also studied at samples after 28 minutes operation, and the results are presented in Table 1.

The flank wear did not differ significant between the samples A, B, C and D.

**Table 1. Results from wear tests in accordance with Example 1.**

| Sample | Pattern | Surface area coverage of pattern at first substrate surface | Crater wear: Area exposed of substrate after 28 min [mm²] | Crater wear: Area exposed of substrate after 36 min [mm²] | Crater wear: Area exposed of substrate after 40 min [mm²] | Crater wear: Area exposed of substrate after 44 min [mm²] | Crater depth after 28 min [µm] |
|---|---|---|---|---|---|---|---|
| A (invention) | Grooves perpendicular to edge | 59% coating | 0.08 | 0.175 | Not analysed | 0.208 | 23 |
| B (invention) | Grooves parallel with edge | 59% coating | 0.049 | 0.144 | Not analysed | 0.223 | Not analysed |
| C (invention) | Crossed grooves | 83% coating | 0.071 | 0.098 | Not analysed | 0.142 | 3 |
| D (reference) | No grooves | 0% coating | 0.203 | 0372 | 0.64 | Not analysed | 21 |

### Example 2

Tools provided with a patterned area comprising crossed grooves as disclosed above, were compared to reference tools without any patterned area, wherein different coating thicknesses were studied. Samples E and F were coated with an inner 5.5 µm thick MT-TiCN layer, an 4 µm thick α-alumina layer and an 1.2 µm thick outermost TiN coating. Sample G and H were coated with an inner 8.5 µm thick MT-TiCN layer, an 4.5 µm thick α-alumina layer and an 1.2 µm thick outermost TiN coating. Sample I and J were coated with an inner 10 µm thick MT-TiCN layer, an 10 µm thick α-alumina layer and an 0.8 µm thick outermost TiN coating. All the inserts were finally treated with a wet blasting with 220 mesh Al₂O₃ grits.

The cutting tools made in accordance with above were evaluated with respect to crater wear in a continual longitudinal turning operation in ball bearing steel (Ovako 825B) with depth of cut 2 mm, cutting speed 220 m/min, feed speed 0.3 mm/rev and using coolant. The stop criteria was set to: crater area of 0.2 mm², or obvious plastic deformation of the cutting edge, and cutting times required to reach any of these criterias. A cutting edge with any of those two levels of wear is considered worn out and the life time of the cutting edge reached. The test was also stopped if the flank wear, defined as the distance seen from the flank side between the edge line and unworn coating, exceeded 0.4 mm. The results as an average of two parallel tests are presented in Table 2.

As can be seen in Table 2, the sample E with the crossed grooves and the thinnest coating with a total thickness of 10.5 µm suffered from plastic deformation while the corresponding reference F to the corresponding without grooves that suffered from excessive crater wear. The sample G with crossed grooves and a coating thickness of 13.5 µm also suffered from plastic deformation while the corresponding reference, sample H, suffered from excessive crater wear. The thickest coating tested in this example has a thickness of 21 µm, and in this case both the reference, sample J, and the patterned sample, sample I, showed a flank wear of more than 0.4 mm, while only the reference sample J suffered from excessive crater wear. The conclusion is therefore that the patterned tools do have increased resistance to crater wear.

**Table 2. Results from wear tests in accordance with Example 2.**

| Sample | Surface pattern | Coating | Total coating thickness, T_{c} [µm] | Average life length [min] | Critical wear mechanism | Wₗ/T_{c} |
|---|---|---|---|---|---|---|
| E (comparative) | Crossed | 5.5 µm TiCN | 10.5 | 12 | Plastic deformation | 27/10.5=2.57 |
| | grooves | 4 µm Al₂O₃ | | | | |
| | | 1.2 µm TiN | | | | |
| F (reference) | No pattern | 5.5 µm TiCN | 10.5 | 13 | Excessive crater wear | |
| | | 4 µm Al₂O₃ | | | | |
| | | 1.2 µm TiN | | | | |
| G (invention) | Crossed | 8.5 µm TiCN | 13.5 | 20 | Plastic deformation | 27/13.5=2 |
| | grooves | 4.5 µm Al₂O₃ | | | | |
| | | 1.2 µm TiN | | | | |
| H (reference) | No pattern | 8.5 µm TiCN | 13.5 | 17 | Excessive crater wear | |
| | | 4.5 µm Al₂O₃ | | | | |
| | | 1.2 µm TiN | | | | |
| I (invention) | Crossed | 10 µm TiCN | 21 | >28 | Flank wear ≥ 0.4 mm | 27/21=1.29 |
| | grooves | 10 µm Al₂O₃ | | | | |
| | | 0.8 µm TiN | | | | |
| J(reference) | No pattern | 10 µm TiCN | 21 | 28 | Excessive crater wear Flank wear ≥ 0.4 mm | |
| | | 10 µm Al₂O₃ | | | | |
| | | 0.8 µm TiN | | | | |

The present invention is above described with the substrate being made of cemented carbide. However, the advantageous effect of locally having an increased effective thickness of the coating may be accomplished in substrates for cutting tools made of different materials as well such as ceramics, cermets, cubic boron nitride, polycrystalline diamond, high speed steel.

While the invention has been described in connection with various exemplary embodiments, it is to be understood that the invention is not to be limited to the disclosed exemplary embodiments, on the contrary, it is intended to cover various modifications and equivalent arrangements within the appended claims.

## Claims

1. A coated cutting tool comprising a substrate (1) and a surface coating (2) deposited on the substrate (1) and covering at least a portion of the substrate (1), the surface coating (2) having a thickness T_{c}, wherein the substrate (1) comprises a plurality of recesses into the substrate (1) within a patterned surface area within the coated portion of the substrate, **characterized in that** each of said recesses has a depth D, wherein 2 µm <D< 100 µm, a width Wᵢ at half depth [D/2] of the recess, where Wᵢ≤2T_{c}, and T_{c} is between 2 µm and 30 µm, and wherein the recess is at least partly filled by the surface coating (2), wherein the coating comprises an inner layer made of Ti(C,O,N), Ti(C,N), TiC, TiN, or combinations thereof with thickness T_{ci} and an outer layer made of Al₂O₃ with thickness T_{co}.

2. The coated cutting tool of claim 1, wherein the patterned surface area of the substrate (1) comprises a first surface (4) of the substrate (1) provided with recesses into the substrate (1), and wherein the thickness of the coating deposited in the recess, as measured in a direction perpendicular to said first surface (4) of the substrate (1), is larger than the coating deposited outside the recess on the first surface (4) of the substrate (1).

3. The coated cutting tool according to claim 2, wherein the surface coating (2) has an outer surface (6) and wherein a point (5) at a maximum depth of a remaining recess at the outer surface (6) is located above a first surface (4) of the substrate (1) such that the coating (2) is continuous along a line parallel to the first surface (4) of the substrate (1) across several recesses.

4. The coated cutting tool of any of the preceding claims, wherein the pitch P between two adjacent recesses is larger than 10 µm and smaller than 100 µm.

5. The coated cutting tool of any of the preceding claims, wherein the patterned surface area comprises recesses covering 50-98% of the nominal surface area.

6. The coated cutting tool of any of the preceding claims, wherein each recess has an aspect ratio D/Wₑ<2, wherin Wₑ is the width of the recess at a first surface (4) of the substrate (1).

7. The coated cutting tool of any of the preceding claims, wherein the surface coating is deposited by chemical vapour deposition.

8. The coated cutting tool of any of the preceding claims, wherein each recess is a groove.

9. The coated cutting tool of any of the preceding claims, wherein the grooves are arranged in a pattern with crossing grooves forming islands enclosed by the grooves.

10. The coated cutting tool according to any of claims 1-7, wherein the recess is a pit or a groove with a curved outer shape such as a ring or an oval.

11. The coated cutting tool of any of claim 9, wherein a maximum width of said islands is less than 100 µm.

12. The coated cutting tool of any of the preceding claims, wherein the cutting tool comprises a rake face and a flank face and wherein the patterned surface area is on a rake face of the coated cutting tool.

13. The coated cutting tool of claim 12, wherein the patterned surface area covers a crater area on the rake face of the coated cutting tool, wherein the crater area is an area with increased risk for crater wear.

14. The coated cutting tool according to any of the preceeding claims, wherein the coating comprises several layers made of compound of one or several first elements selected from Group 4, Group 5, Group 6 (IUPAC) and one or several second elements selected from N, B, O, C.

15. The coated cutting tool according to any of the preceeding claims, wherein the coating comprises several layers made of compound of one or several first elements selected from Group 4, Group 5, Group 6 (IUPAC), Al or Si, and one or several second elements selected from N, B, O, C.

16. The coated cutting tool according to any of the preceding claims wherein Wᵢ<2T_{ci}.

17. The coated cutting tool according to any of the preceding claims, wherein Wᵢ<2(T_{ci} +T_{co}).

## Patentansprüche

1. Beschichtetes Schneidwerkzeug, welches ein Substrat (1) und eine Oberflächenbeschichtung (2) aufweist, die auf dem Substrat (1) abgeschieden ist und zumindest einen Teil des Substrats (1) abdeckt, wobei die Oberflächenbeschichtung (2) eine Dicke (T_{c}) hat, wobei das Substrat (1) eine Mehrzahl von Vertiefungen in dem Substrat (1) in einem gemusterten Oberflächenbereich innerhalb des beschichteten Teiles des Substrates hat, **dadurch gekennzeichnet, dass** jede der Vertiefungen eine Tiefe (D) hat, wobei 2 µm < D < 100 µm ist, eine Breite (Wᵢ) bei der Hälfte der Tiefe [D/2 der Vertiefung hat, wobei Wᵢ ≤ 2 T_{c} und wobei T_{c} zwischen 2 µm und 30 µm liegt, und wobei die Vertiefung zumindest teilweise mit der Oberflächenbeschichtung (2) ausgefüllt ist, wobei die Beschichtung eine innere Schicht aufweist, die aus Ti (C, O, N), Ti (C, N), TiC, TiN oder Kombinationen hieraus mit einer Dicke (T_{ci}) aufweist, sowie eine äußere Schicht, die aus Al₂O₃ hergestellt ist, mit einer Dicke von T_{co}.

2. Beschichtetes Schneidwerkzeug nach Anspruch 1, wobei der gemusterte Oberflächenbereich des Substrates (1) eine erste Fläche (4) des Substrates (1) aufweist, die mit Vertiefungen in dem Substrat (1) versehen ist, und wobei die Dicke der in der Vertiefung abgeschiedenen Beschichtung, gemessen in einer Richtung senkrecht zu der ersten Fläche (4) des Substrates (1), größer als die Dicke der Beschichtung ist, die außerhalb der Vertiefung auf der ersten Oberfläche (4) des Substrates (1) abgeschieden wurde.

3. Beschichtetes Schneidwerkzeug nach Anspruch 2, wobei die Oberflächenbeschichtung (2) eine äußere Oberfläche (6) hat und wobei ein Punkt (5) bei einer maximalen Tiefe einer verbleibenden Vertiefung auf der äußeren Oberfläche (6) oberhalb einer ersten Fläche (4) des Substrates (1) liegt, sodass die Beschichtung (2) entlang einer Linie parallel zu der ersten Fläche (4) des Substrates (1) über mehrere Vertiefungen hinweg kontinuierlich zusammenhängend ist.

4. Beschichtetes Schneidwerkzeug nach einem der vorstehenden Ansprüche, wobei der Wiederholabstand P zwischen zwei benachbarten Vertiefungen größer als 10 µm und kleiner als 100 µm ist.

5. Beschichtetes Schneidwerkzeug nach einem der vorstehenden Ansprüche, wobei der gemusterte Oberflächenbereich Vertiefungen aufweist, die 50 bis 98 Prozent der nominellen Oberfläche bedecken.

6. Beschichtetes Schneidwerkzeug nach einem der vorstehenden Ansprüche, wobei jede Vertiefung ein Aspektverhältnis D/Wₑ < 2 hat, wobei Wₑ die Breite der Vertiefung auf einer ersten Oberfläche (4) des Substrates (1) ist.

7. Beschichtetes Schneidwerkzeug nach einem der vorstehenden Ansprüche, wobei die Oberflächenbeschichtung durch chemische Dampfabscheidung abgeschieden ist.

8. Beschichtetes Schneidwerkzeug nach einem der vorstehenden Ansprüche, wobei die Vertiefung eine Nut ist.

9. Beschichtetes Schneidwerkzeug nach einem der vorstehenden Ansprüche, wobei die Nuten in einem Muster aus einander kreuzenden Nuten angeordnet sind, welche von den Nuten eingeschlossene Inseln bilden.

10. Beschichtetes Schneidwerkzeug nach einem der Ansprüche 1 bis 7, wobei die Vertiefung eine Vertiefung oder eine Nut mit einer gekrümmten äußeren Form, wie zum Beispiel ein Ring oder ein Oval, ist.

11. Beschichtetes Schneidwerkzeug nach Anspruch 9, wobei eine maximale Breite der Inseln weniger als 100 µm beträgt.

12. Beschichtetes Schneidwerkzeug nach einem der vorstehenden Ansprüche, wobei das Schneidwerkzeug eine Spanfläche und eine Freifläche aufweist, wobei der gemusterte Flächenbereich sich auf einer Spanfläche des beschichteten Schneidwerkzeuges befindet.

13. Beschichtetes Schneidwerkzeug nach Anspruch 12, wobei der gemusterte Flächenbereich einen Kraterbereich auf der Spanfläche des beschichteten Schneidwerkzeuges abdeckt, wobei der Kraterbereich ein Bereich mit einem erhöhten Risiko für Kraterverschleiß ist.

14. Beschichtetes Schneidwerkzeug nach einem der vorstehenden Ansprüche, wobei die Beschichtung mehrere Lagen aufweist, die aus einem Verbund aus einem oder mehreren ersten Elementen hergestellt sind, welche ausgewählt sind aus der Gruppe 4, der Gruppe 5 und der Gruppe 6 (IUPAC) und einem oder mehreren zweiten Elementen, die ausgewählt wurden aus N, B, O und C.

15. Beschichtetes Schneidwerkzeug nach einem der vorstehenden Ansprüche, wobei die Beschichtung mehrere Lagen aufweist, die aus einem Verbund aus einem oder mehreren ersten Elementen hergestellt sind, die ausgewählt wurden aus der Gruppe 4, 5, 6 (IUPAC), Al oder Si ausgewählt wurden, und einem oder mehreren zweiten Elementen, die aus N, B, O und C ausgewählt wurden.

16. Beschichtetes Schneidwerkzeug nach einem der vorstehenden Ansprüche, wobei Wᵢ < 2 Tc ist.

17. Beschichtetes Schneidwerkzeug nach einem der vorstehenden Ansprüche, wobei Wᵢ < 2 (T_{ci} + T_{co}) ist.

## Revendications

1. Outil de coupe revêtu comprenant un substrat (1) et un revêtement de surface (2) déposé sur le substrat (1) et couvrant au moins une partie du substrat (1), le revêtement de surface (2) ayant une épaisseur T_{c}, dans lequel le substrat (1) comprend une pluralité de creux dans le substrat (1) dans une zone de surface à motif dans la partie revêtue du substrat, **caractérisé en ce que** chacun desdits creux a une profondeur D, dans lequel 2 µm < D < 100 µm, une largeur Wᵢ à la moitié de la profondeur [D/2] du creux, où Wᵢ ≤ 2 ≤ T_{c}, et T_{c} se trouve entre 2 µm et 30 µm, et dans lequel le creux est au moins partiellement rempli par le revêtement de surface (2), dans lequel le revêtement comprend une couche intérieure constituée de Ti(C, O, N), Ti(C, N), TiC, TiN, ou des combinaisons de ceux-ci avec une épaisseur T_{ci} et une couche extérieure constituée de Al₂O₃ avec une épaisseur T_{co}.

2. Outil de coupe revêtu selon la revendication 1, dans lequel la zone de surface à motif du substrat (1) comprend une première surface (4) du substrat (1) dotée de creux dans le substrat (1), et dans lequel l'épaisseur du revêtement déposé dans le creux, mesurée dans une direction perpendiculaire à ladite première surface (4) du substrat (1), est plus grande que le revêtement déposé à l'extérieur du creux sur la première surface (4) du substrat (1).

3. Outil de coupe revêtu selon la revendication 2, dans lequel le revêtement de surface (2) possède une surface extérieure (6) et dans lequel un point (5) à une profondeur maximale d'un creux restant au niveau de la surface extérieure (6) est situé au-dessus d'une première surface (4) du substrat (1) de sorte que le revêtement (2) soit continu le long d'une ligne parallèle à la première surface (4) du substrat (1) sur plusieurs creux.

4. Outil de coupe revêtu selon l'une quelconque des revendications précédentes, dans lequel le pas P entre deux creux adjacents est plus grand que 10 µm et plus petit que 100 µm.

5. Outil de coupe revêtu selon l'une quelconque des revendications précédentes, dans lequel la zone de surface à motif comprend des creux couvrant 50 à 98 % de la zone de surface nominale.

6. Outil de coupe revêtu selon l'une quelconque des revendications précédentes, dans lequel chaque creux a un rapport de forme D / Wₑ < 2, dans lequel Wₑ est la largeur du creux au niveau d'une première surface (4) du substrat (1).

7. Outil de coupe revêtu selon l'une quelconque des revendications précédentes, dans lequel le revêtement de surface est déposé par dépôt chimique en phase vapeur.

8. Outil de coupe revêtu selon l'une quelconque des revendications précédentes, dans lequel chaque creux est une rainure.

9. Outil de coupe revêtu selon l'une quelconque des revendications précédentes, dans lequel les rainures sont disposées suivant un motif avec des rainures croisées formant des îlots entourés par les rainures.

10. Outil de coupe revêtu selon l'une quelconque des revendications 1 à 7, dans lequel le creux est une cuvette ou une rainure avec une forme extérieure incurvée comme un anneau ou un ovale.

11. Outil de coupe revêtu selon l'une quelconque de la revendication 9, dans lequel une largeur maximale desdits îlots est inférieure à 100 µm.

12. Outil de coupe revêtu selon l'une quelconque des revendications précédentes, dans lequel l'outil de coupe comprend une face de coupe et une face de dépouille et dans lequel la zone de surface à motif est sur une face de coupe de l'outil de coupe revêtu.

13. Outil de coupe revêtu selon la revendication 12, dans lequel la zone de surface à motif couvre une zone de cratère sur la surface de coupe de l'outil de coupe revêtu, dans lequel la zone de cratère est une zone avec un risque accru d'usure en cratère.

14. Outil de coupe revêtu selon l'une quelconque des revendications précédentes, dans lequel le revêtement comprend plusieurs couches constituées d'un composé d'un ou plusieurs premiers éléments sélectionnés à partir du Groupe 4, du Groupe 5, du Groupe 6 (IUAPC) et d'un ou plusieurs deuxièmes éléments sélectionnés parmi N, B, O, C.

15. Outil de coupe revêtu selon l'une quelconque des revendications précédentes, dans lequel le revêtement comprend plusieurs couches constituées d'un composé d'un ou plusieurs premiers éléments sélectionnés à partir du Groupe 4, du Groupe 5, du Groupe 6 (IUAPC), A1 ou Si, et d'un ou plusieurs deuxièmes éléments sélectionnés parmi N, B, O, C.

16. Outil de coupe revêtu selon l'une quelconque des revendications précédentes, dans lequel Wᵢ < 2T_{ci}.

17. Outil de coupe revêtu selon l'une quelconque des revendications précédentes, dans lequel Wᵢ < 2(T_{ci} + T_{co}).
